# EUROPEAN PATENT APPLICATION

(11) **EP 4 645 702 A1**
(43) Date of publication of application: **05.11.2025**
(21) Application number: 25171188.3
(22) Date of filing: 17.04.2025
(51) Int. Cl.: H03M 1/10, H03M 1/12

(54) **METHOD AND APPARATUS FOR CHECKING PLAUSIBILITY OF ANALOG INPUT DATA**

(30) Priority: 03.05.2024 KR 20240059479
(71) Applicant: Hanwha Solutions Corporation, Jung-gu Seoul 04541 (KR)
(72) Inventor: LEE, Joon Min, 04541 Seoul (KR); YU, Min-ho, 04541 Seoul (KR); KIM, Young Cheol, 04541 Seoul (KR); AHN, Eun Ji, 04541 Seoul (KR); HONG, Min Ki, 04541 Seoul (KR)
(74) Representative: Mooser, Sebastian Thomas

(57) **Abstract**

Provided are a method and apparatus for checking plausibility of analog input data. The method may include selecting input data corresponding to a channel selection signal, based on a multiplexer, and generating digital data by converting the input data into a digital form, based on an analog-to-digital (A/D) converter. The method may include determining a presence or absence of a first error in the digital data, based on a storage position of the digital data. The method may include determining a presence or absence of a second error in the digital data, based on a comparison between the digital data and a preset threshold value. The method may include determining an error of at least one of the multiplexer or the A/D converter, based on the presence or absence of the first error and the presence or absence of the second error.

## Description

### BACKGROUND

### 1. Field

The disclosure relates to a method and apparatus for checking plausibility of analog input data.

### 2. Description of the Related Art

A conventional method of checking plausibility of analog input data has a problem in that it is difficult to perform checking according to a type of input data. For example, in a conventional method of checking whether analog input is within an acceptable range, there is a problem in that it is difficult to check a fault/error of a multiplexer (MUX) in case that external analog input data has an alternating current (AC) form.

Accordingly, there is a growing demand for technology that checks plausibility, regardless of a type of external input data.

The aforementioned background technology is technical information possessed by the inventor for derivation of the disclosure or acquired by the inventor during the derivation of the disclosure, and is not necessarily prior art disclosed to the public before the application of the disclosure.

### SUMMARY

The disclosure provides a method and apparatus for checking plausibility of analog input data. In addition, the disclosure provides a computer-readable recording medium having recorded thereon a program for causing a computer to perform the method.

The problems to be solved by the disclosure are not limited to those described above, and other problems and advantages of the disclosure that are not described herein will be understood from the following description and will be more clearly understood from embodiments. In addition, it will be appreciated that the problems to be solved by the disclosure and the advantages may be realized by the means indicated in the patent claims and combinations thereof.

A first aspect of the disclosure provides a method of checking plausibility of analog input data, the method including selecting input data corresponding to a channel selection signal, based on a multiplexer, and generating digital data by converting the input data into a digital form, based on an analog-to-digital (A/D) converter, determining a presence or absence of a first error in the digital data, based on a storage position of the digital data, determining a presence or absence of a second error in the digital data, based on a comparison between the digital data and a preset threshold value, and determining an error of at least one of the multiplexer or the A/D converter, based on the presence or absence of the first error and the presence or absence of the second error, wherein the input data includes a preset direct current voltage.

A second aspect of the disclosure provides an apparatus for checking plausibility of analog input data, the apparatus including at least one memory and at least one processor, wherein the at least one processor is configured to select input data corresponding to a channel selection signal, based on a multiplexer, and generate digital data by converting the input data into a digital form, based on an analog-to-digital (A/D) converter, determine a presence or absence of a first error in the digital data, based on a storage position of the digital data, determine a presence or absence of a second error in the digital data, based on a comparison between the digital data and a preset threshold value, and determine an error of at least one of the multiplexer or the A/D converter, based on the presence or absence of the first error and the presence or absence of the second error, wherein the input data includes a preset direct current voltage.

A third aspect of the disclosure may provide a computer-readable recording medium having recorded thereon a program for causing a computer to perform the method according to the first aspect.

In addition, other methods and other systems for implementing the disclosure and computer-readable recording media storing a computer program for performing the methods may be further provided.

Other aspects, features, and advantages of the disclosure will become better understood through the accompanying drawings, the appended claims, and the detailed description.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a diagram illustrating an example of a system for checking plausibility of analog input data, according to an embodiment;
FIG. 2A is a configuration diagram illustrating an example of a user terminal according to an embodiment;
FIG. 2B is a configuration diagram illustrating an example of a server according to an embodiment;
FIG. 3 is a flowchart showing an example of a method of checking plausibility of analog input data, according to an embodiment;
FIG. 4 is a diagram illustrating another example of a system for checking plausibility of analog input data, according to an embodiment;
FIG. 5 is a flowchart illustrating an example of a method, performed by a processor, of determining a presence or absence of a second error, according to an embodiment;
FIG. 6 is a diagram illustrating an example in which a processor determines a presence or absence of a second error, based on an upper limit value and a lower limit value, according to an embodiment;
FIG. 7 is a diagram illustrating an example in which a processor determines an error of an analog-to-digital conversion (ADC) unit, based on a presence or absence of an error in a plurality of channels, according to an embodiment; and
FIGS. 8 to 10 are diagrams illustrating another example of a system for checking plausibility of analog input data, according to an embodiment.

### DETAILED DESCRIPTION

Hereinafter, various embodiments will be described in connection with the accompanying drawings. As the disclosure allows for various changes and numerous embodiments, specific embodiments are illustrated in the drawings and described in detail. However, this is not intended to limit various embodiments to specific embodiments, and it will be understood that the disclosure includes all modifications, equivalents, and substitutes falling within the spirit and scope of various embodiments. In connection with the description of the drawings, like reference numbers may be used to denote like elements.

The expressions "include" or "may include," which may be used in various embodiments, indicate the presence of the functions, operations, components, etc., disclosed herein and do not limit one or more additional functions, operations, or components, etc. In addition, it will be understood that the terms "comprise," "include," or "have" as used in various embodiments specify the presence of the features, numbers, steps, operations, elements, components, or any combination thereof stated in the specification, but do not preclude the presence or addition of one or more other features, numbers, steps, operations, elements, components, or any combination thereof.

In various embodiments, the expression "or" and the like includes any and all combinations of words listed together. For example, the expression "A or B" may include only A, only B, or both A and B.

The expression "first," "second," etc. used in various embodiments may modify various components of various embodiments, but do not limit the components. For example, the expressions described above do not limit the order and/or importance of the components. The expressions described above may be used to distinguish one component from another. For example, a first user device and a second user device are both user devices and represent different user devices. For example, while not departing from the scope of various embodiments, a first element may be referred to as a second element, and similarly, a second element may be referred to as a first element.

In the embodiments, the terms such as "module," "unit," "part," etc. are terms used to denote components that perform at least one function or operation, and such components may be implemented as hardware, software, or a combination of hardware and software. In addition, a plurality of "modules," "units," "parts," etc. may be integrated into at least one module or chip and implemented as at least one processor, except in case that the plurality of "modules," "units," "parts," etc. need to be implemented as individual specific hardware.

The terms used in the various embodiments are used only to describe particular embodiments and are not intended to limit the various embodiments. The singular forms as used herein are intended to include the plural forms as well unless the context clearly indicates otherwise.

Unless defined otherwise, all terms including technical or scientific terms as used herein have the same meaning as commonly understood by those of ordinary skill in the art to which various embodiments belong.

It will be understood that terms, such as those defined in commonly used dictionaries, should be interpreted as having a meaning that is consistent with their meaning in the context of the relevant art and will not be interpreted in an idealized or overly formal sense unless expressly so defined in various embodiments.

Hereinafter, various embodiments will be described in detail with reference to the accompanying drawings.

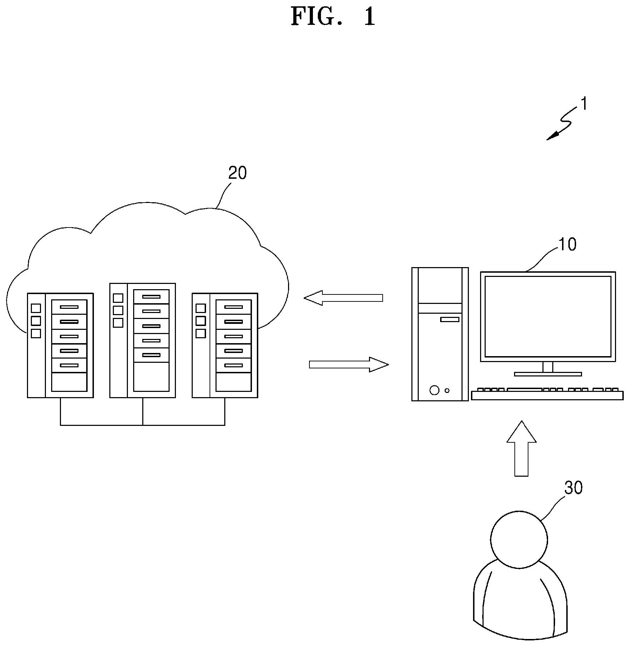

FIG. 1 is a diagram illustrating an example of a system 1 for checking plausibility of analog input data, according to an embodiment.

Referring to FIG. 1, the system 1 may include a user terminal 10 and a server 20. For example, the user terminal 10 and the server 20 may be connected to each other in a wired or wireless communication scheme and transmit and receive data therebetween.

For convenience of explanation, FIG. 1 illustrates that the system 1 includes the user terminal 10 and the server 20, but the disclosure is not limited thereto. For example, the system 1 may include other external devices (not shown), and the operations of the user terminal 10 and the server 20 described below may be implemented by a single device (e.g., the user terminal 10 or the server 20) or a plurality of devices.

The user terminal 10 may be a computing device that includes a display device, a device (e.g., a keyboard, a mouse, etc.) that receives user input, a memory, and a processor. For example, the display device may be implemented as a touch screen to receive user input. Examples of the user terminal 10 may include a notebook personal computer (PC), a desktop PC, a laptop, a tablet computer, a smartphone, etc., but the disclosure is not limited thereto.

The server 20 may be a device that communicates with an external device (not shown) that includes the user terminal 10. As an example, the server 20 may be a device that stores various data including input data, digital data, etc. For example, the server 20 may be a computing device that includes a memory and a processor and has built-in computing capabilities. As an example, the server 20 may perform at least some of the operations of the user terminal 10, which will be described below with reference to FIGS. 1 to 10. The server 20 may be, for example, a cloud server, but the disclosure is not limited thereto.

The user terminal 10 may determine an error of a multiplexer (MUX) and/or an analog-to-digital (A/D) converter included in an analog-to-digital conversion (ADC) unit. For example, the user terminal 10 may determine an error of the MUX and/or the A/D converter by analyzing digital data generated through the MUX and the A/D converter.

For example, the user terminal 10 may determine an error of the MUX and/or the A/D converter by analyzing digital data generated by using an additional MUX. For example, the user terminal 10 may select direct current (DC) input through the additional MUX, generate digital data by converting the selected DC input into a digital form, based on the MUX and the A/D converter included in the ADC unit, and determine an error of the MUX and/or the A/D converter by analyzing the generated digital data.

For example, the user terminal 10 may generate input data, based on a digital-to-analog (D/A) converter, and determine an error of the MUX and/or the A/D converter by analyzing digital data generated by converting the generated input data into a digital form. For example, the user terminal 10 may generate analog data by converting the digital data into an analog form, based on the D/A converter, and use the generated analog data as the input data. The user terminal 10 may determine an error of the MUX and/or the A/D converter by analyzing the digital data generated by converting the generated analog data into a digital form.

For convenience of explanation, it has been described throughout the specification that the user terminal 10 selects input data corresponding to a channel selection signal, based on the MUX, generates digital data by converting the input data into a digital form, based on the A/D converter, determines a presence or absence of a first error in the digital data, based on a storage position of the digital data, determines a presence or absence of a second error in the digital data, based on a comparison between the digital data and a preset threshold value, and determines an error of at least one of the MUX or the A/D converter, based on the presence or absence of the first error and the presence or absence of the second error, but the disclosure is not limited thereto. For example, at least some of the operations that are performed by the user terminal 10 may be performed by the server 20.

In other words, at least some of the operations of the user terminal 10 described below with reference to FIGS. 1 to 10 may be performed by the server 20. For example, the server 20 may select input data corresponding to the channel selection signal, based on the MUX, generate digital data by converting the input data into a digital form, based on the A/D converter, determine the presence or absence of the first error in the digital data, based on the storage position of the digital data, determine the presence or absence of the second error in the digital data, based on a comparison between the digital data and the preset threshold value, and determine an error of at least one of the MUX or the A/D converter, based on the presence or absence of the first error and the presence or absence of the second error.

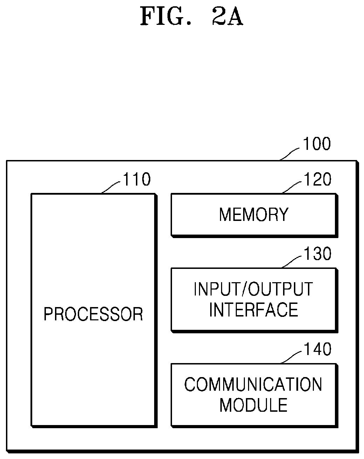

FIG. 2A is a configuration diagram illustrating an example of a user terminal 100 according to an embodiment.

Referring to FIG. 2A, the user terminal 100 may include a processor 110, a memory 120, an input/output interface 130, and a communication module 140. For convenience of explanation, only elements related to the disclosure are illustrated in FIG. 2A. Accordingly, in addition to the elements illustrated in FIG. 2A, other general-purpose elements may be further included in the user terminal 100. It is obvious to those of ordinary skill in the art that the processor 110, the memory 120, the input/output interface 130, and the communication module 140 illustrated in FIG. 2A may be implemented as independent devices.

The processor 110 may process commands of a computer program by performing basic arithmetic, logic, and input/output operations. The commands may be provided from the memory 120 or an external device (e.g., the server 20, etc.). For example, the processor 110 may control the overall operations of other elements included in the user terminal 100.

The processor 110 may select input data corresponding to a channel selection signal, based on a MUX, and generate digital data by converting the input data into a digital form, based on an A/D converter.

The processor 110 may determine a presence or absence of a first error in the digital data, based on a storage position of the digital data. For example, the processor 110 may determine the presence or absence of the first error in the digital data, based on whether the channel selection signal and the storage position of the digital data correspond to each other.

The processor 110 may determine a presence or absence of a second error in the digital data, based on a comparison between the digital data and a preset threshold value. As an example, the processor 110 may set an upper limit value and a lower limit value for the input data and determine the presence or absence of the second error in the digital data, based on whether the digital data satisfies a range between the upper limit value and the lower limit value. As another example, the processor 110 may calculate a count in which the digital data is greater than a preset threshold value, and determine the presence or absence of the second error in the digital data, based on a comparison between the count and a threshold count set based on the input data.

The processor 110 may determine an error of at least one of the MUX or the A/D converter, based on the presence or absence of the first error and the presence or absence of the second error. As an example, the processor 110 may determine that the first error has occurred in case that the channel selection signal for selecting the input data and the storage position of the digital data do not correspond to each other, and may determine an error of the MUX, based on the occurrence of the first error. As another example, the processor 110 may determine that the second error has occurred in case that the digital data generated through the A/D converter is out of a range of the preset threshold value, and may determine an error of the A/D converter, based on the occurrence of the second error.

For example, the processor 110 may select input data corresponding to a channel selection signal, based on an additional MUX. The selected input data may be output from an output terminal of the additional MUX and input to an input terminal of the MUX.

For example, the processor 110 may generate input data by converting digital data into an analog form, based on a D/A converter.

For example, the processor 110 may generate input data by converting digital data into an analog form, based on the D/A converter, and select input data generated through the D/A converter, based on the additional MUX.

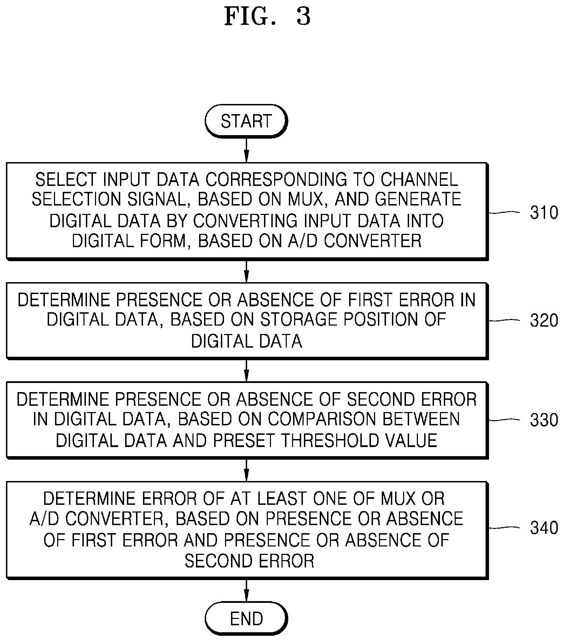

Specific examples of the operation of the processor 110 according to an embodiment are described with reference to FIGS. 3 to 10.

The processor 110 may be implemented as an array of a plurality of logic gates, or may be implemented as a combination of a general-purpose microprocessor and a memory storing a program that is executable on the microprocessor. Examples of the processor 110 may include a general-purpose processor, a central processing unit (CPU), a microprocessor, a digital signal processor (DSP), a controller, a microcontroller, and a state machine. In some environments, the processor 110 may include an application-specific integrated circuit (ASIC), a programmable logic device (PLD), a field programmable gate array (FPGA), or the like. For example, the processor 110 may be a combination of processing devices, for example, a combination of a DSP and a microprocessor, a combination of a plurality of microprocessors, a combination of one or more microprocessors connected to a DSP core, or a combination of any other configurations.

The memory 120 may include any non-transitory computer-readable recording medium. As an example, the memory 120 may include a permanent mass storage device, such as random access memory (RAM), read-only memory (ROM), disk drive, solid state drive (SSD), or flash memory. As another example, the permanent mass storage device, such as ROM, SSD, flash memory, or disk drive, may be a separate permanent storage device distinct from memory. For example, the memory 120 may store an operating system (OS) and at least one program code (e.g., code for causing the processor 110 to perform operations to be described below with reference to FIGS. 3 to 10).

Such software components may be loaded from a computer-readable recording medium separate from the memory 120. The separate computer-readable recording medium may be a recording medium that may be directly connected to the user terminal 100. Examples of the separate computer-readable recording medium may include floppy drive, disk, tape, digital versatile disc/compact disc read-only memory (DVD/CD-ROM) drive, and memory card. For example, the software components may be loaded into the memory 120 through the communication module 140 rather than the computer-readable recording medium. For example, the at least one program may be loaded into the memory 120, based on a computer program installed by files provided through the communication module 140 by developers or a file distribution system that distributes an application installation file (e.g., a computer program for causing the processor 110 to perform operations described below with reference to FIGS. 3 to 10).

The input/output interface 130 may be a means for interfacing with an input or output device (e.g., a keyboard, a mouse, etc.) that may be connected to or included in the user terminal 100. The input/output interface 130 is configured separately from the processor 110, but the disclosure is not limited thereto, and the input/output interface 130 may be configured to be included in the processor 110.

The communication module 140 may provide a configuration or a function for the server 20 and the user terminal 100 to communicate with each other via a network. For example, the communication module 140 may provide a configuration or a function for the user terminal 100 to communicate with other external devices. For example, control signals, commands, data, and the like, which are provided under the control of the processor 110, may be transmitted to the server 20 and/or an external device via the communication module 140 and the network.

Although not illustrated in FIG. 2A, the user terminal 100 may further include a display device. For example, the display device may be implemented as a touch screen. For example, the user terminal 100 may be connected to an independent display device in a wired or wireless communication scheme and may transmit and receive data therebetween. For example, the presence or absence of the first error, the presence or absence of the second error, the error of at least one of the MUX or the A/D converter, etc. may be provided through the display device.

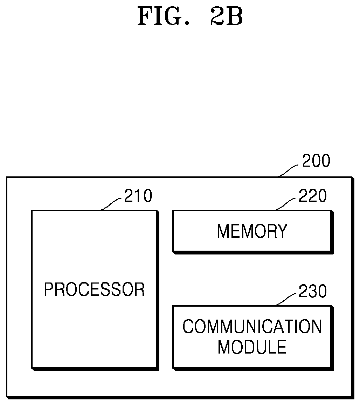

FIG. 2B is a configuration diagram illustrating an example of a server 200 according to an embodiment.

Referring to FIG. 2B, the server 200 may include a processor 210, a memory 220, and a communication module 230. For convenience of explanation, only elements related to the disclosure are illustrated in FIG. 2B. Accordingly, in addition to the elements illustrated in FIG. 2B, other general-purpose elements may be further included in the server 200. It is obvious to those of ordinary skill in the art that the processor 210, the memory 220, the communication module 230 illustrated in FIG. 2B may be implemented as independent devices.

The processor 210 may select input data corresponding to a channel selection signal, based on a MUX, and generate digital data by converting the input data into a digital form, based on an A/D converter. The processor 210 may determine a presence or absence of a first error in the digital data, based on a storage position of the digital data. The processor 210 may determine a presence or absence of a second error in the digital data, based on a comparison between the digital data and a preset threshold value. The processor 210 may determine an error of at least one of the MUX or the A/D converter, based on the presence or absence of the first error and the presence or absence of the second error.

In other words, at least one of the operations of the processor 110 described above with reference to FIG. 2A may be performed by the processor 210. In this case, the user terminal 100 may output information transmitted from the server 200 through the display device.

Because the embodiment of the processor 210 is the same as the embodiment of the processor 110 described above with reference to FIG. 2A, a detailed description thereof is omitted.

The memory 220 may store various data, including data necessary for the operation of the processor 210 or data generated according to the operation of the processor 210. The memory 220 may store an OS and at least one program (e.g., a program necessary for the operation of the processor 210, etc.).

Because the embodiment of the memory 220 is the same as the embodiment of the memory 120 described above with reference to FIG. 2A, a detailed description thereof is omitted.

The communication module 230 may provide a configuration or a function for the server 200 and the user terminal 100 to communicate with each other via a network. The communication module 230 may provide a configuration or a function for the server 200 to communicate with other external devices. For example, control signals, commands, data, and the like, which are provided under the control by the processor 210, may be transmitted to the user terminal 100 and/or an external device via the communication module 230 and the network.

FIG. 3 is a flowchart showing an example of a method of checking plausibility of analog input data, according to an embodiment.

Referring to FIG. 3, the method of checking plausibility of analog input data may include operations processed in time series by the user terminals 10 and 100 or the processor 110 illustrated in FIGS. 1 and 2A. Therefore, even when omitted below, the descriptions of the user terminals 10 and 100 or the processor 110 illustrated in FIGS. 1 to 2A may also be applied to the method of checking plausibility of analog input data as illustrated in FIG. 3.

Furthermore, as described above with reference to FIGS. 1 and 2B, at least one of the operations of the method of checking plausibility of analog input data as illustrated in FIG. 3 may be processed by the servers 20 and 200 or the processor 210.

In operation 310, the processor 110 may select input data corresponding to a channel selection signal, based on a MUX, and generate digital data by converting the input data into a digital form, based on the A/D converter. For example, the processor 110 may control the MUX to select the input data through the channel selection signal. The selected input data may be output from the output terminal of the MUX, input to the A/D converter, and converted into a digital form through the A/D converter. The digital data generated by converting the input data into a digital form may be output from the A/D converter and input to the processor 110.

The input data may include a preset DC voltage. For example, the input data may include at least one of: first input data including at least one of an alternating current (AC) voltage or a DC voltage; and second input data including a DC voltage set to be different from the first input data.

In case that external input data is two or more AC voltages, there is a problem in that it is difficult to determine a presence or absence of an error of the MUX, based only on a position where the digital data is stored. According to an embodiment, an error of the MUX and the A/D converter may be accurately determined by using the preset DC voltage as the input data.

According to an embodiment, an error of at least one of the MUX or the A/D converter may be determined by determining a presence or absence of a first error or a presence or absence of a second error, based on the digital data generated by converting the input data including the DC voltage into a digital form.

In operation 320, the processor 110 may determine the presence or absence of the first error in the digital data, based on a storage position of the digital data. The processor 110 may determine the presence or absence of the first error in the digital data by determining whether the storage position of the digital data is the same as a set storage position. In case that the storage position of the digital data is not the same as the set storage position, the processor 110 may determine that the first error has occurred.

The processor 110 may determine the presence or absence of the first error in the digital data, based on whether the channel selection signal and the storage position of the digital data correspond to each other. The channel selection signal is a signal which is input to the MUX so as to select the input data, and the position where the output digital data is stored corresponds to each channel selection signal. In other words, the channel selection signals may correspond to the storage positions of the digital data, respectively, and the processor 110 may determine the presence or absence of the first error by determining whether the digital data generated by converting the analog data selected according to the channel selection signal into a digital form is stored in the storage position corresponding to the channel selection signal. In case that the storage position of the digital data is not the same as the storage position corresponding to the channel selection signal, the processor 110 may determine that the first error has occurred.

In operation 330, the processor 110 may determine the presence or absence of the second error in the digital data, based on a comparison between the digital data and a preset threshold value. For example, in case that the digital data is out of a range of a preset threshold value, the processor 110 may determine that the second error has occurred in the digital data. The preset threshold value may be set based on the input data.

The processor 110 may set an upper limit value and a lower limit value for the input data and determine the presence or absence of the second error in the digital data, based on whether the digital data satisfies a range between the upper limit value and the lower limit value.

In some embodiments, the upper limit value and the lower limit may be set within a range between VREFHI and VREFLO (or VSSA). For example, the upper limit value may be set based on VREFHI, and the lower limit value may be set based on VREFLO (or VSSA). However, examples of the upper limit value and the lower limit are not limited to those described above.

For example, the upper limit value and the lower limit value may be calculated based on a first error of at least one of a resistor or an IC element existing in a circuit including the MUX and the A/D converter and a second error of an ADC unit including the MUX and the A/D converter. For example, the first error may include a maximum value of an error range of a resistor and an IC element existing on a printed circuit board (PCB) from an external input to a microcontroller unit (MCU). The second error may include a maximum value of an error for a measurement range existing in an ADC unit included in the MCU. Each of the upper limit value and the lower limit value may be calculated based on a combination of the first error and the second error. The processor 110 may calculate the maximum value and the minimum value, based on the combination of the first error and the second error, and may set the upper limit value and the lower limit value by assigning a margin error (e.g., 5 %, 10 %, 15 %, etc.). However, an example in which the processor 110 sets the upper limit value and the lower limit value, based on the first error and the second error, is not limited to those described above.

In some embodiments, the processor 110 may set the upper limit value for the input data and determine the presence or absence of the second error in the digital data, based on whether the digital data generated by converting the input data into a digital form is less than or equal to the upper limit value. In other words, the processor 110 may determine the presence or absence of the second error in the digital data, based on a comparison between the digital data and the preset upper limit value.

In some embodiments, the processor 110 may calculate a count in which the digital data is greater than a preset threshold value, and determine the presence or absence of the second error in the digital data, based on a comparison between the count and a threshold count set based on the input data. The processor 110 may calculate a consecutive count in which the digital data is greater than a preset threshold value. In other words, the processor 110 may reset the count in case that the digital data is within the preset threshold value again even when greater than the preset threshold value.

In operation 340, the processor 110 may determine an error of at least one of the MUX or the A/D converter, based on the presence or absence of the first error and the presence or absence of the second error. In case that the processor 110 determines that the first error has occurred, the processor 110 may determine that an error has occurred in the MUX included in the ADC unit. For example, in case that the processor 110 determines that the second error has occurred, the processor 110 may determine that an error has occurred in the A/D converter included in the ADC unit. In other words, in case that the processor 110 determines that the first error and the second error have not occurred, the processor 110 may determine that no error has occurred in the ADC unit including the MUX and the A/D converter.

In some embodiments, the processor 110 may determine an error of the ADC unit by using an additional MUX and/or a D/A converter. The additional MUX and/or the D/A converter may be included in the ADC unit, or may be provided as devices separate from the ADC unit.

As an example, the processor 110 may select input data corresponding to a channel selection signal, based on the additional MUX. The input data may be output from an output terminal of the additional MUX and input to an input terminal of the MUX.

As another example, the processor 110 may generate the input data by converting the digital data into an analog form, based on the D/A converter.

As another example, the processor 110 may generate input data by converting digital data into an analog form, based on the D/A converter, and select input data generated through the D/A converter, based on the additional MUX.

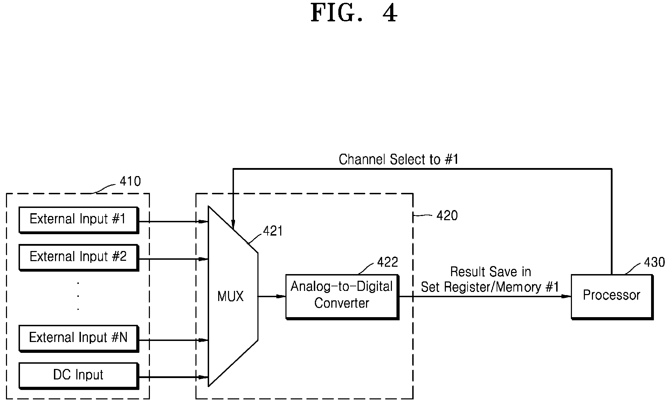

FIG. 4 is a diagram illustrating another example of a system (or an MCU) for checking plausibility of analog input data, according to an embodiment.

Referring to FIG. 4, the MCU may include an ADC unit 420 and a processor 430. For example, the ADC unit 420 may generate digital data by converting analog input data into a digital form and transmit the digital data to the processor 430. For convenience of explanation, only elements related to the disclosure are illustrated in FIG. 4. Accordingly, in addition to the elements illustrated in FIG. 4, other general-purpose elements may be further included in the MCU.

The ADC unit 420 may include a MUX 421 and an A/D converter 422. The MUX 421 may receive input data 410 including at least one of external inputs #1 to #N or DC input, select input data corresponding to a channel selection signal transmitted by the processor 430, and output the selected input data to the A/D converter 422.

The A/D converter 422 may generate digital data by converting, into a digital form, the input data selected and output by the MUX 421 in response to the channel selection signal of the processor 430. The generated digital data may be input to the processor 430 and stored in a storage position corresponding to the channel selection signal.

The processor 430 may determine a presence or absence of a first error in the digital data, based on the storage position of the digital data. The processor 430 may determine a presence or absence of a second error in the digital data, based on a comparison between the digital data and a preset threshold value. The processor 430 may determine an error of at least one of the MUX or the A/D converter, based on the presence or absence of the first error and the presence or absence of the second error.

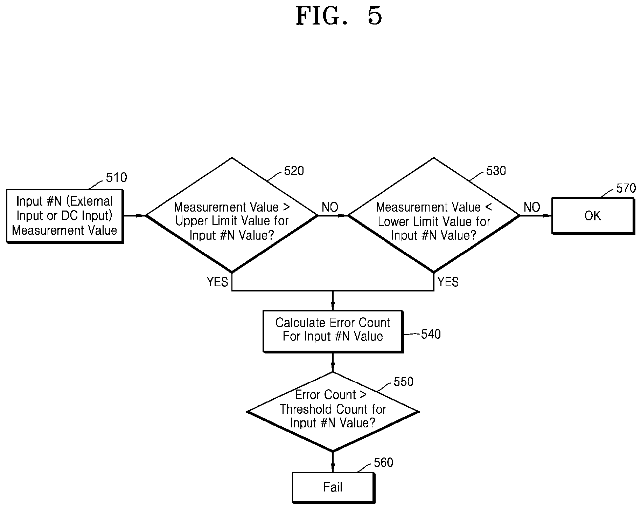

FIG. 5 is a flowchart illustrating an example of a method, performed by the processor 110 of FIG. 2A, of determining a presence or absence of a second error, according to an embodiment.

In operation 510, the processor 110 may obtain an input #N measurement value. An input #N value refers to input data including one of external inputs #1 to #N and DC input. The input #N measurement value refers to digital data generated by converting one of the external inputs #1 to #N and the DC input into a digital form.

In operation 520, the processor 110 may compare the obtained input #N measurement value with an upper limit value for the input #N value. In case that the input #N measurement value is greater than the upper limit value, the processor 110 may determine that an error has occurred.

In operation 530, the processor 110 may compare the obtained input #N measurement value with a lower limit value for the input #N value. In case that the input #N measurement value is less than the lower limit value, the processor 110 may determine that an error has occurred.

In operation 540, the processor 110 may calculate an error count for the input #N value in response to determining that an error has occurred in operations 520 and 530. The error count may include the number of times the input #N measurement value is greater than the upper limit value or the input #N measurement value is less than the lower limit value. In some embodiments, the error count may include only the number of consecutive times.

In operation 550, the processor 110 may compare the error count calculated in operation 540 with a threshold count for the input #N value. In operation 560, in case that the error count is greater than the threshold count for the input #N value, the processor 110 may determine that the second error has occurred.

In case that the measurement value is less than or equal to the upper limit value for the input #N value in operation 520 and the measurement value is greater than or equal to the lower limit value for the input #N value in operation 530, the processor 110 may determine that the second error has not occurred.

Although the flowchart illustrated in FIG. 5 is described as an example, examples of the method of determining the presence or absence of the second error are not limited to those described above. For example, in the flowchart illustrated in FIG. 5, operations 520 and 530 are described sequentially, but operation 530 may be performed before operation 520, or operations 520 and 530 may be configured and performed in parallel.

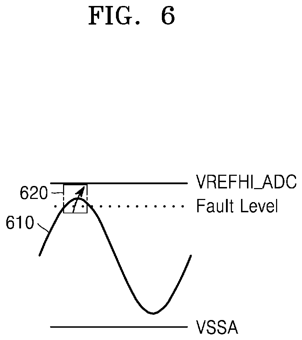

FIG. 6 is a diagram illustrating an example in which the processor 110 of FIG. 2A determines a presence or absence of a second error, based on an upper limit value and a lower limit value, according to an embodiment.

Referring to FIG. 6, the processor 110 may set a fault level, which is the upper limit value, based on VREFHI. The processor 110 may calculate a count in which digital data 610 is greater than the fault level. In case that the count is greater than a threshold count, the processor 110 may determine that the second error has occurred.

In some embodiments, the processor 110 may set the lower limit value, based on VSSA. At this time, the lower limit value may be VSSA or 0. In other words, the processor 110 may determine the presence or absence of the second error by setting the lower limit value to VSSA or 0, or by setting only the upper limit value without setting the lower limit value.

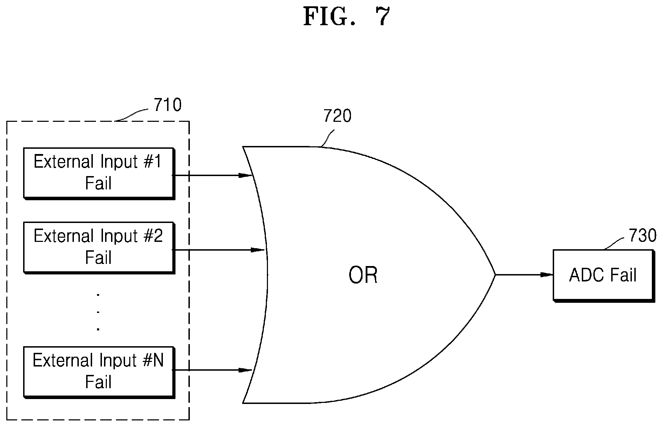

FIG. 7 is a diagram illustrating an example in which the processor 110 of FIG. 2A determines an error of an ADC unit, based on a presence or absence of an error for a plurality of channels, according to an embodiment.

Referring to FIG. 7, the processor 110 may determine the error of the ADC unit, based on a presence or absence of a first error and a presence or absence of a second error in each of the plurality of channels (channels #1 to #N). For example, in case that the processor 110 determines that the first error or the second error has occurred in at least one of the plurality of channels (channels #1 to #N), the processor 110 may determine the error of the ADC unit.

However, examples of determining the error of the ADC unit are not limited to those described above.

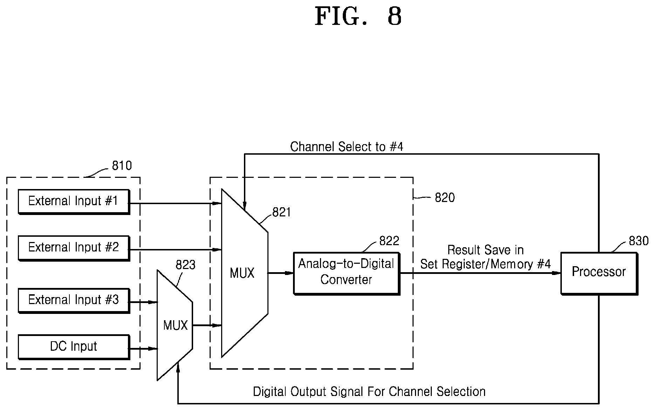

FIGS. 8 to 10 are diagrams illustrating another example of a system (or an MCU) for checking plausibility of analog input data, according to an embodiment.

Referring to FIG. 8, the MCU may include an additional MUX 823, an ADC unit 820, and a processor 830. For example, the ADC unit 820 may generate digital data by converting analog input data into a digital form and transmit the digital data to the processor 830. For convenience of explanation, only elements related to the disclosure are illustrated in FIG. 8. Accordingly, in addition to the elements illustrated in FIG. 8, other general-purpose elements may be further included in the MCU.

The ADC unit 820 may include a MUX 821 and an A/D converter 822. The MUX 821 may receive input data 810 including at least one of external inputs #1 to #N or DC input, select input data corresponding to a channel selection signal transmitted by the processor 830, and output the selected input data to the A/D converter 822.

In some embodiments, the ADC unit 820 may receive the input data selected based on the additional MUX 823. For example, the processor 830 may select and output DC input, based on the additional MUX 823, and input the selected DC input to the MUX 821 as the input data.

The A/D converter 822 may generate digital data by converting, into a digital form, the input data selected and output by the MUX 821 in response to the channel selection signal of the processor 830. The generated digital data may be input to the processor 830 and stored in a storage position corresponding to the channel selection signal.

The processor 830 may determine a presence or absence of a first error in the digital data, based on the storage position of the digital data. The processor 830 may determine a presence or absence of a second error in the digital data, based on a comparison between the digital data and a preset threshold value. The processor 830 may determine an error of at least one of the MUX or the A/D converter, based on the presence or absence of the first error and the presence or absence of the second error.

Examples of determining an error of a MUX and an A/D converter by using an additional MUX are not limited to the example illustrated in FIG. 8.

According to an embodiment, an error of a MUX and an A/D converter for additional external input may be determined by selecting input data, based on an additional MUX.

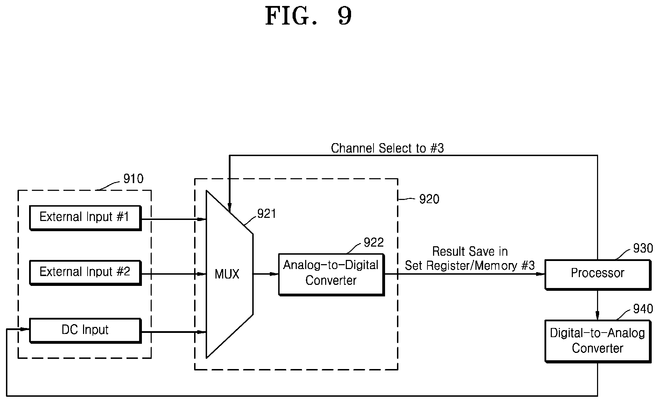

Referring to FIG. 9, the MCU may include an ADC unit 920, a processor 930, and a D/A converter 940. For example, the ADC unit 920 may generate digital data by converting analog input data into a digital form and transmit the digital data to the processor 930. For convenience of explanation, only elements related to the disclosure are illustrated in FIG. 9. Accordingly, in addition to the elements illustrated in FIG. 9, other general-purpose elements may be further included in the MCU.

The ADC unit 920 may include a MUX 921 and an A/D converter 922. The MUX 921 may receive input data 910 including at least one of external inputs #1 to #N or DC input, select input data corresponding to a channel selection signal transmitted by the processor 930, and output the selected input data to the A/D converter 922.

The A/D converter 922 may generate digital data by converting, into a digital form, the input data selected and output by the MUX 921 in response to the channel selection signal of the processor 930. The generated digital data may be input to the processor 930 and stored in a storage position corresponding to the channel selection signal.

The processor 930 may determine a presence or absence of a first error in the digital data, based on the storage position of the digital data. The processor 930 may determine a presence or absence of a second error in the digital data, based on a comparison between the digital data and a preset threshold value. The processor 930 may determine an error of at least one of the MUX 921 or the A/D converter 922, based on the presence or absence of the first error and the presence or absence of the second error.

In some embodiments, the processor 930 may generate the input data by transmitting the digital data to the D/A converter 940. The D/A converter 940 may generate analog data by converting the digital data received from the processor 930 into an analog form. The generated analog data may include DC input. The MUX 921 may receive the input data 910 including the DC input generated by the D/A converter 940, select input data corresponding to a channel selection signal transmitted by the processor 930, and output the selected input data to the A/D converter 922.

Examples of determining an error of a MUX and an A/D converter by using a D/A converter are not limited to the example illustrated in FIG. 9.

According to an embodiment, an error of a MUX and an A/D converter may be accurately determined by generating input data, based on a D/A converter.

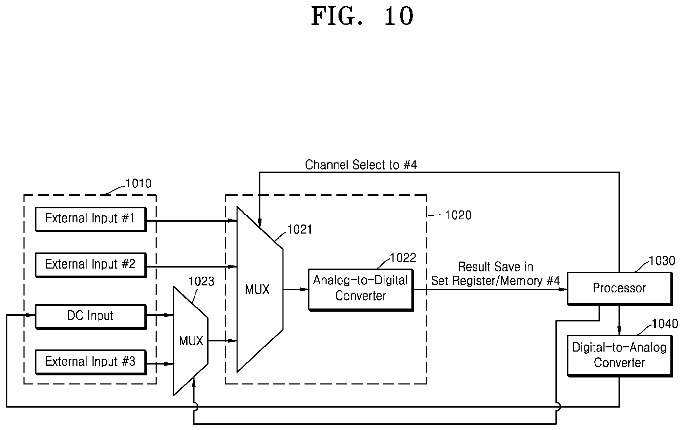

Referring to FIG. 10, the MCU may include an additional MUX 1023, an ADC unit 1020, a processor 1030, and a D/A converter 1040. For example, the ADC unit 1020 may generate digital data by converting analog input data into a digital form and transmit the digital data to the processor 1030. For convenience of explanation, only elements related to the disclosure are illustrated in FIG. 10. Accordingly, in addition to the elements illustrated in FIG. 10, other general-purpose elements may be further included in the MCU.

The ADC unit 1020 may include a MUX 1021 and an A/D converter 1022. The MUX 1021 may receive input data 1010 including at least one of external inputs #1 to #N or DC input, select input data corresponding to a channel selection signal transmitted by the processor 1030, and output the selected input data to the A/D converter 1022.

In some embodiments, the ADC unit 1020 may receive the input data selected based on the additional MUX 1023. For example, the processor 1030 may select and output DC input, based on the additional MUX 1023, and input the selected DC input to the MUX 1021 as the input data.

The A/D converter 1022 may generate digital data by converting, into a digital form, the input data selected and output by the MUX 1021 in response to the channel selection signal of the processor 1030. The generated digital data may be input to the processor 1030 and stored in a storage position corresponding to the channel selection signal.

The processor 1030 may determine a presence or absence of a first error in the digital data, based on the storage position of the digital data. The processor 1030 may determine a presence or absence of a second error in the digital data, based on a comparison between the digital data and a preset threshold value. The processor 1030 may determine an error of at least one of the MUX 1021 or the A/D converter 1022, based on the presence or absence of the first error and the presence or absence of the second error.

In some embodiments, the processor 1030 may generate the input data by transmitting the digital data to the D/A converter 1040. The D/A converter 1040 may generate analog data by converting the digital data received from the processor 1030 into an analog form. The generated analog data may include DC input. The additional MUX 1023 may receive the input data 1010 including the DC input generated by the D/A converter 1040, select input data corresponding to a channel selection signal transmitted by the processor 1030, and output the selected input data to the A/D converter 1022.

Examples of determining an error of a MUX and an A/D converter by using an additional MUX and a D/A converter are not limited to the example illustrated in FIG. 10.

According to an embodiment, an error of a MUX and an A/D converter for additional external input may be accurately determined by selecting input data, based on an additional MUX and a D/A converter.

As described above, the processor 110 may select input data corresponding to a channel selection signal, based on the MUX, generate digital data by converting the input data into a digital form, based on the A/D converter, determine a presence or absence of a first error in the digital data, based on a storage position of the digital data, determine a presence or absence of a second error in the digital data, based on a comparison between the digital data and a preset threshold value, and determine an error of at least one of the MUX or the A/D converter, based on the presence or absence of the first error and the presence or absence of the second error. Accordingly, the error of the MUX and the A/D converter may be determined more accurately.

The processor 110 may determine the error of the MUX and the A/D converter in various situations, regardless of the type of input data.

The processor 110 may more accurately determine the error of the MUX and the A/D converter by using the generated DC voltage as the input data.

The processor 110 may determine the error of the MUX and the A/D converter for additional external input by using the additional MUX.

According to the solution to problem described above, input data corresponding to a channel selection signal may be selected, based on the MUX, digital data may be generated by converting the input data into a digital form, based on the A/D converter, a presence or absence of a first error in the digital data may be determined, based on a storage position of the digital data, a presence or absence of a second error in the digital data may be determined, based on a comparison between the digital data and a preset threshold value, and an error of at least one of the MUX or the A/D converter may be determined, based on the presence or absence of the first error and the presence or absence of the second error. Accordingly, the error of the MUX and the A/D converter may be determined more accurately.

In the disclosure, the error of the MUX and the A/D converter may be determined in various situations, regardless of the type of input data.

In the disclosure, the error of the MUX and the A/D converter may be determined accurately determined by using the generated DC voltage as the input data.

Furthermore, in the disclosure, the error of the MUX and the A/D converter for additional external input may be determined by using the additional MUX.

The effects of the disclosure are not limited to those described above, and other effects that are not described herein will be clearly understood from the description of the claims by those of ordinary skill in the art.

The methods described above may be written as a program that is executable on a computer, and may be implemented in a general-purpose digital computer that operates the program by using a computer-readable recording medium. In addition, data structures used in the methods described above may be recorded on a computer-readable recording medium through a variety of means. The computer-readable recording medium may include a storage medium, such as a magnetic storage medium (e.g., read-only memory (ROM), random access memory(RAM), universal serial bus (USB), floppy disk, hard disk, etc.) and an optical reading medium (e.g., compact disc-ROM (CD-ROM), digital versatile disc (DVD), etc.).

The methods described above may be provided by being included in a computer program product. The computer program product may be traded between a seller and a buyer as commodities. The computer program product may be distributed in the form of a machine-readable storage medium (e.g., CD-ROM), or may be distributed (e.g., downloaded or uploaded) online, either via an application store (e.g., Play Store^{™}) or directly between two user devices. In the case of the online distribution, at least part of the computer program product may be stored at least temporarily on a machine-readable storage medium, such as a server of a manufacturer, a server of an application store, or a memory of a relay server, or may be temporarily generated.

Those of ordinary skill in the art will understand that the disclosure may be implemented in modified forms without departing from the essential features of the disclosure. Therefore, the disclosed methods should be considered in an illustrative sense rather than a restrictive sense. The scope of the disclosure is indicated in the claims rather than the foregoing description, and all differences within the scope equivalent thereto should be construed as falling within the scope of the disclosure.

## Claims

1. A method comprising:
selecting input data corresponding to a channel selection signal, based on a multiplexer, and generating digital data by converting the input data into a digital form, based on an analog-to-digital (A/D) converter;
determining a presence or absence of a first error in the digital data, based on a storage position of the digital data;
determining a presence or absence of a second error in the digital data, based on a comparison between the digital data and a preset threshold value; and
determining an error of at least one of the multiplexer or the A/D converter, based on the presence or absence of the first error and the presence or absence of the second error,
wherein the input data comprises a preset direct current voltage.

2. The method of claim 1, wherein the input data comprises at least one of: first input data comprising at least one of an alternating current voltage or a direct current voltage; and second input data comprising a direct current voltage set to be different from the first input data.

3. The method of claim 1 or 2, wherein the determining of the presence or absence of the first error comprises determining the presence or absence of the first error in the digital data, based on whether the channel selection signal and the storage position of the digital data correspond to each other.

4. The method of any one of claims 1 to 3, wherein the determining of the presence or absence of the second error comprises:
setting an upper limit value and a lower limit value for the input data; and
determining the presence or absence of the second error in the digital data, based on whether the digital data satisfies a range between the upper limit value and the lower limit value.

5. The method of any one of claims 1 to 4, wherein the determining of the presence or absence of the second error comprises:
calculating a count in which the digital data deviates from the preset threshold value; and
determining the presence or absence of the second error in the digital data, based on a comparison between the count and a threshold count set based on the input data.

6. The method of any one of claims 1 to 5, further comprising selecting the input data corresponding to the channel selection signal, based on an additional multiplexer,
wherein the input data is output from an output terminal of the additional multiplexer and input to an input terminal of the multiplexer.

7. The method of any one of claims 1 to 6, further comprising generating the input data by converting the digital data into an analog form, based on a digital-to-analog (D/A) converter.

8. An apparatus comprising:
at least one memory; and
at least one processor,
wherein the at least one processor is configured to:
select input data corresponding to a channel selection signal, based on a multiplexer, and generate digital data by converting the input data into a digital form, based on an analog-to-digital (A/D) converter;
determine a presence or absence of a first error in the digital data, based on a storage position of the digital data;
determine a presence or absence of a second error in the digital data, based on a comparison between the digital data and a preset threshold value; and
determine an error of at least one of the multiplexer or the A/D converter, based on the presence or absence of the first error and the presence or absence of the second error,
wherein the input data comprises a preset direct current voltage.

9. The apparatus of claim 8, wherein the input data comprises at least one of: first input data comprising at least one of an alternating current voltage or a direct current voltage; and second input data comprising a direct current voltage set to be different from the first input data.

10. The apparatus of claim 8 or 9, wherein the at least one processor is further configured to determine the presence or absence of the first error in the digital data, based on whether the channel selection signal and the storage position of the digital data correspond to each other.

11. The apparatus of any one of claims 8 to 10, wherein the at least one processor is further configured to:
set an upper limit value and a lower limit value for the input data; and
determine the presence or absence of the second error in the digital data, based on whether the digital data satisfies a range between the upper limit value and the lower limit value.

12. The apparatus of any one of claims 8 to 11, wherein the at least one processor is further configured to:
calculate a count in which the digital data deviates from the preset threshold value; and
determine the presence or absence of the second error in the digital data, based on a comparison between the count and a threshold count set based on the input data.

13. The apparatus of any one of claims 8 to 12, wherein the at least one processor is further configured to select the input data corresponding to the channel selection signal, based on an additional multiplexer,
wherein the input data is output from an output terminal of the additional multiplexer and input to an input terminal of the multiplexer.

14. The apparatus of any one of claims 8 to 13, wherein the at least one processor is further configured to generate the input data by converting the digital data into an analog form, based on a digital-to-analog (D/A) converter.

15. A computer-readable recording medium having recorded thereon a program for causing a computer to perform the method of any one of claims 1 to 7.
